# EUROPEAN PATENT SPECIFICATION

(11) **EP 1 947 693 B1**
(45) Date of publication and mention of the grant of the patent: **25.03.2015**
(21) Application number: 07100750.4
(22) Date of filing: 18.01.2007
(51) Int. Cl.: H01L 25/075, B32B 17/10, H05K 1/02, H01L 33/62, F21S 4/00, H05K 1/18

(54) **Plane structure of light-emitting diode lighting apparatus**
Flächenstruktur einer Leuchtdioden-Beleuchtungsvorrichtung
Structure plate d'appareil d'éclairage à diodes électroluminescentes

(43) Date of publication of application: 23.07.2008
(73) Proprietor: Polytron Technologies, Inc., Taoyuan City, Taiwan (TW)
(72) Inventor: Yu, Sam, Taoyuan County, Taoyuan City (TW); Cheng, Dalong, Taoyuan County, Taoyuan City (TW)
(74) Representative: Reichert & Lindner Partnerschaft Patentanwälte

(56) References cited:
- EP-A- 1 437 215
- EP-A- 1 445 804
- EP-A- 1 715 521
- EP-A1- 1 450 416
- WO-A-2004/017434
- WO-A-2005/099310
- FR-A1- 2 812 071

## Description

### BACKGROUND OF THE INVENTION

### 1. FIELD OF THE INVENTION

The present invention relates to a plane structure of a lighting apparatus and more especially, relates to a plane structure of a light-emitting diode lighting apparatus.

### 2. DESCRIPTION OF THE PRIOR ART

With the development and progress of the technology, light-emitting diode (LED) plays an important role on various application due to its low thermal dissipation, low power consumption, long life, quick response, small volume, good vibration resistance, no gas discharge and plate package. Thus, light-emitting diode may be applied on the products of lighting, prospect design, transportation instruction and electric display.

For example, on the application of prospect beautification, a lighting system with light-emitting diode may present effects on the varieties of color light not only to provide the function of ambient lighting but also to generate colorful enrichment with low power consumption. However, the application of light-emitting diode is provided generally with light-emitting diodes associated with the layout of circuit fixed or attached onto a hard and opaque carrier, which limits the size, dimensions, shape and viewing effect for an applied product.

EP 1 437 215 A discloses a planar light-emitting diode lighting apparatus comprising a PET film, on which an electrically conductive pattern is formed connecting a plurality of LED packages, which are glued onto said PET film, the assembly being sandwiched between two glass plates.

WO 2005/099310 A and EP 1 445 804 A both disclose LEDs having electrodes on opposite sides, which are electrically connected to two different transparent flexible sheets, which both carry contact patterns and sandwich a plurality of such LEDs.

FR 2 812 071 A1 discloses a parallel connection of a plurality of LEDs, wherein a transparent flexible sheet carries two parallel conductor strips, which are optionally transparent. On one of the two strips the LEDs are mounted in a row and one electrode of each LED is electrically connected to that strip, while the second electrode of each LED is connected to the second conductor strip by a wire.

### SUMMARY OF THE INVENTION

According to the issue mentioned previously, one object of the present invention provides a plane structure of light-emitting diodes lighting apparatus. One or more light-emitting diodes are attached on a plane of flexible material and electrically connected via a specialized transparent pattern of the flexible material plane, which may be applied to decorate the furniture, the glass door, the glass window and interior design to prettify the scenery.

Another object of this invention is to provide a plane structure of light-emitting diode lighting apparatus. Conductive material and insulating pattern are formed on a flexible tape, which may stack one layer or multiple layers of light-emitting diodes to diversify the light-emitting diodes deployment and enhance the stereo design to improve effect of prettification and diversion.

Accordingly, the present invention provides plane structure of a light-emitting diode lighting apparatus, comprising:a transparent flexible tape; an electrically conductive transparent pattern and an electrically insulating transparent pattern disposed on said transparent flexible tape, wherein said conductive transparent pattern is divided into a first zone and a second zone in the same plane by said insulating transparent pattern, and said first zone comprises a plurality of first discontinuous blocks electrically connected to an exterior first electrode and said second zone comprises a plurality of second discontinuous blocks electrically connected to an exterior second electrode; the first and second discontinuous blocks being divided by the electrically insulating transparent pattern; and a plurality of light-emitting diodes on said transparent flexible tape, wherein each of said light-emitting diodes has a positive electrode fixed on one of said first blocks and a negative electrode fixed on one of said second blocks.

Other advantages of the present invention will become apparent from the following description taken in conjunction with the accompanying drawings wherein are set forth, by way of illustration and example, certain embodiments of the present invention.

### BRIEF DESCRIPTION OF THE DRAWINGS

The foregoing aspects and many of the accompanying advantages of this invention will become more readily appreciated as the same becomes better understood by reference to the following detailed description, when taken in conjunction with the accompanying drawings, wherein:
FIG. 1A is a cross-sectional diagram of a plane structure of an light-emitting diode lighting apparatus in accordance with a first example
FIG. 1B is a cross-sectional diagram of a plane structure of an light-emitting diodes lighting apparatus in accordance with a second example
FIG. 1C is a front elevation view of one side of the plane structure of the light-emitting diodes lighting apparatus in accordance with FIG. 1A and FIG. 1B;
FIG. 2A is a cross-sectional diagram illustrating the plane structure of the light-emitting diodes lighting apparatus in accordance with a first embodiment of the present invention;
FIG. 2B is a cross-sectional diagram illustrating one side of the plane structure of the light-emitting diodes lighting apparatus in accordance with FIG. 2A;
FIG. 3 is a cross-sectional diagram of the plane structure of the light-emitting diode lighting apparatus in accordance with a third example of the present invention;
FIG. 4A and FIG. 4B are the side elevation view of a lighting apparatus in accordance with an embodiment of the present invention;
FIG. 5 is a flowchart illustrating the formation of the plane structure of the light-emitting diodes lighting apparatus in accordance with an embodiment of the present invention; and
FIG. 6 is a flowchart illustrating the formation of the plane structure of the light-emitting diodes lighting apparatus in accordance with another embodiment of the present invention.

### DETAILED DESCRIPTION OF THE INVENTION

The embodiments of the present invention are illustrated in reference to the drawings.

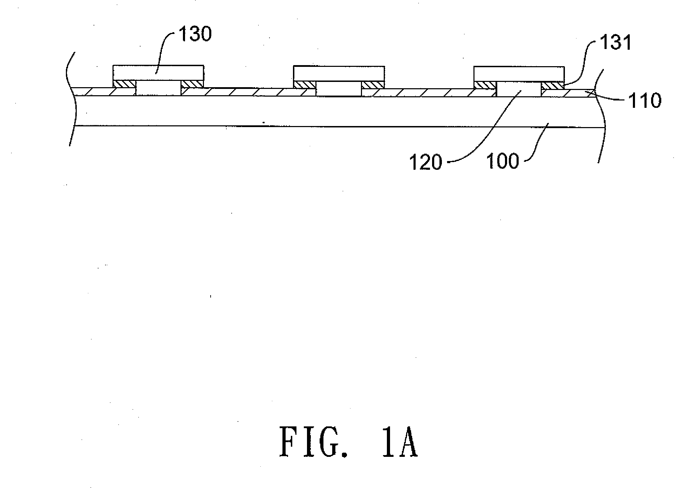

FIG. 1A is a cross-sectional diagram of a plane structure of an LED lighting apparatus in accordance with a first example of the present invention. An light-emitting diodes lighting apparatus includes a first transparent pattern and a second transparent pattern 120 on a transparent flexible tape 100. One or more first light-emitting diodes 130 are attached to the first transparent pattern with adhesive structures 131. In one example the transparent flexible tape 100 is made of insulating and flexible material, such as poly (ethylene terephthalate) (PET), poly carbonate (PC), oriented polypropylene (OPP), poly vinylchlorid (PVC), acrylic or other polymer material, but not limited to. Next, the first transparent pattern, such as a first transparent conductive line 110, but not limited to, is made of such as ITO (Indium Tin Oxide), IZO (Indium Zinc Oxide), or acrylic transparent conductive gel, which is formed on the transparent flexible tape 100 by silk screening or printing. It is appreciated that the first transparent conductive line 110 may be dyed for visual arts.

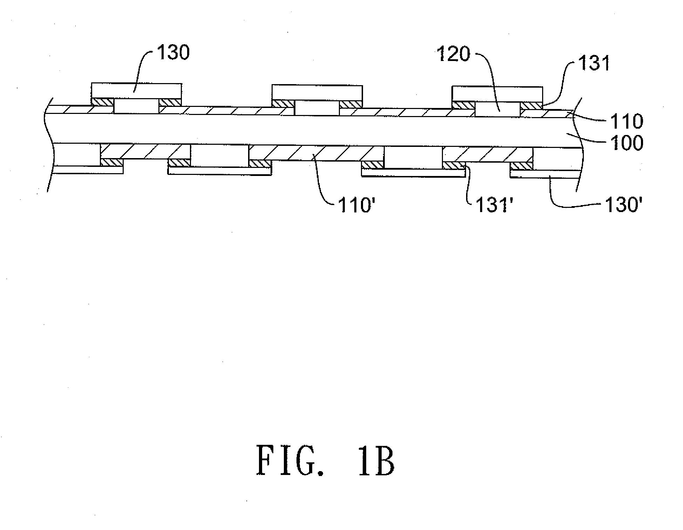

Referring to FIG. 1B, is a cross-sectional diagram of a plane structure of an light-emitting diode lighting apparatus in accordance with a second example of the present invention. In the example the first transparent pattern further includes a first transparent conductive line 110' positioned on the other surface of the transparent flexible tape 100, and one or more first light-emitting diodes 130' are attached to the first transparent conductive line 110' with adhesive structures 131', wherein the first light-emitting diodes 130 and 130' are interlaced so as to decrease the pitch between the first light-emitting diodes 130 and 130' and, furthermore, to increase flexibility of the designs of the lighting apparatus. It is understood that the forming method of the first transparent conductive lines 110' is the same as that mentioned in the first example

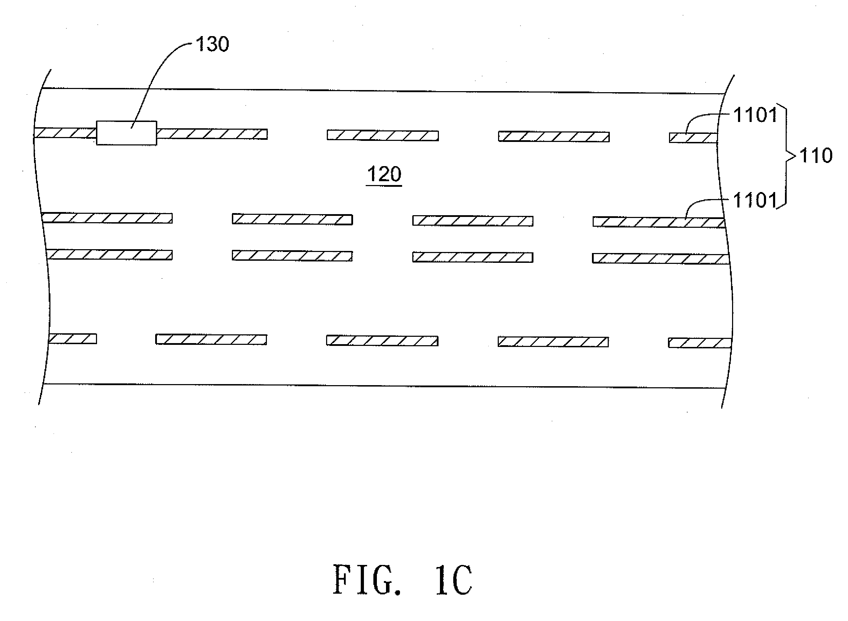

As shown in FIG. 1C presenting the front elevation view of FIG. 1A or FIG. 1B, the first transparent conductive line 110 or 110' has a plurality of discontinuous conductive lines 1101 separated by the second transparent pattern 120, wherein the first transparent conductive line 110 is electrically insulated from the second transparent pattern 120. The second transparent pattern 120 is constituted by one surface of the transparent flexible tape. Alternatively, the second transparent pattern 120 may be constituted by an insulating material which is formed on the surface of the transparent flexible tape. In the example, each light-emitting diode 130 is electrically connected across two ends of the conductive lines 1101. Accordingly, one end of the conductive line 1101 is electrically connected to one or more exterior positive electrodes (not shown) and the other end to one or more exterior negative electrode (not shown), so as to electrically connect the light-emitting diodes 130 to an exterior power supply which provides power to the light-emitting diodes 130 by one or more sets of positive and negative power wires. In addition to the connection of exterior power, the first transparent conductive line 110 may be electrically connected to exterior control lines for controlling the performance of light-emitting diodes 130. Accordingly, the light-emitting diodes 130 may be a monochromatic light-emitting diode or polychromatic light-emitting diode, which are not limited to one type.

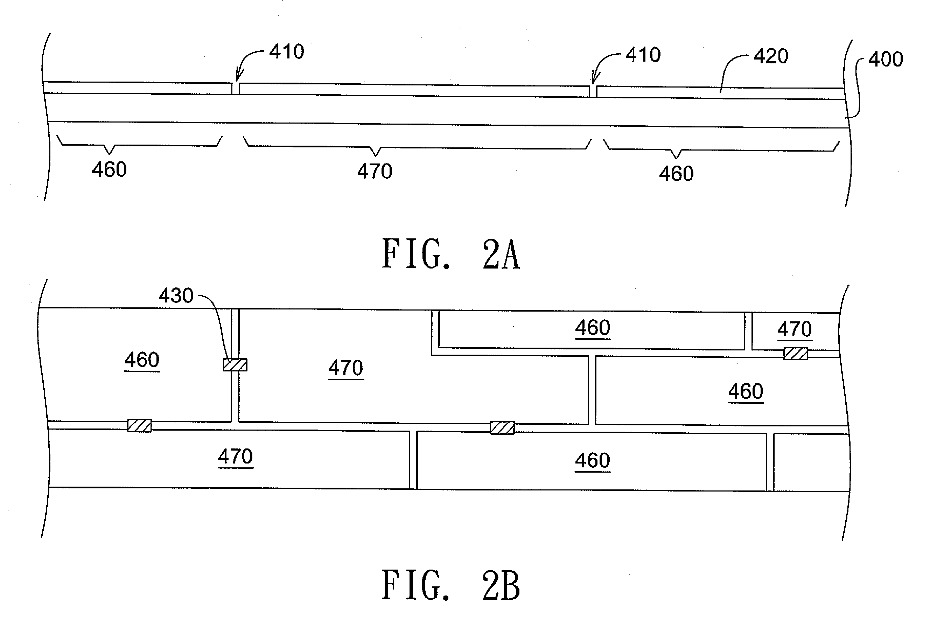

FIG. 2A is a cross-sectional diagram illustrating the plane structure of the light-emitting diode lighting apparatus in accordance with a first embodiment of the present invention. A first transparent pattern is disposed on a transparent flexible tape 400, and, in this embodiment, the first transparent pattern is a transparent conductive film 420, which is divided into a first zone 460 and a second zone 470 by a second transparent pattern 410. In the embodiment, the transparent conductive film 420, not limited to, is made of transparent conductive material such as ITO or IZO, which is formed on the transparent flexible tape 400 by sputtering, evaporate plating, printing or attaching. It is understood that the transparent conductive film 420 may be made with a conductive material implanted a dye or dyes for visual arts. Next, the second transparent pattern 410 will be formed on the transparent conductive film 420 as an insulating pattern by a suitable method, such as laser, chemically etching, printing or cutting, to make the first zone 460 and the second zone 470 electrically insulating from each other.

FIG. 2B is a cross-sectional diagram illustrating one side of the plane structure of the light-emitting diodes lighting apparatus in accordance with FIG. 2A. The first transparent pattern includes the first zone 460 and the second zone 470, and the first zone 460 and the second zone 470 have some discontinuous blocks divided by the second transparent pattern 410. Next, all first blocks of the first zone 460 may electrically or physically be connected to one or more first exterior electrodes (in this embodiment, the first exterior electrodes are positive electrodes). Similarly, all second blocks of the second zone 470 may electrically or physically be connected to one or more second exterior electrodes which are different from the first exterior electrodes (in this embodiment, the second exterior electrodes are negative electrodes). Furthermore, one or more light-emitting diodes 430 are attached across the second transparent pattern 410, wherein each light-emitting diode 430 has a positive electrode fixed on one first block of the first zone 460 and a negative electrode fixed on one second block of the second zone 470. Accordingly,

the first zone 460 may be connected to one or more exterior positive electrodes, as well as the second zone 470 to one or more exterior negative electrodes.

It is understood, the light-emitting diode lighting apparatus can be evolved as a double-side light-emitting diode lighting apparatus by forming another first transparent pattern and another second transparent pattern on the other surface of the transparent flexible tape. That is, the first transparent patterns of both sides of the transparent flexible tape are made of conductive material. Besides, the conductive material may be selected from the groups consisted of transparent acrylic conductive gel, indium tin oxide, and indium zinc oxide. And, the second transparent pattern includes at least one of the surfaces of the transparent flexible tape or an insulation layer. And the only criterion to establish such a double-side light-emitting diode lighting apparatus is that all light-emitting diodes on both sides of the lighting apparatus have to overlapped across positioned, as this result, the light-emitting diodes lighting apparatus can display the visual arts.

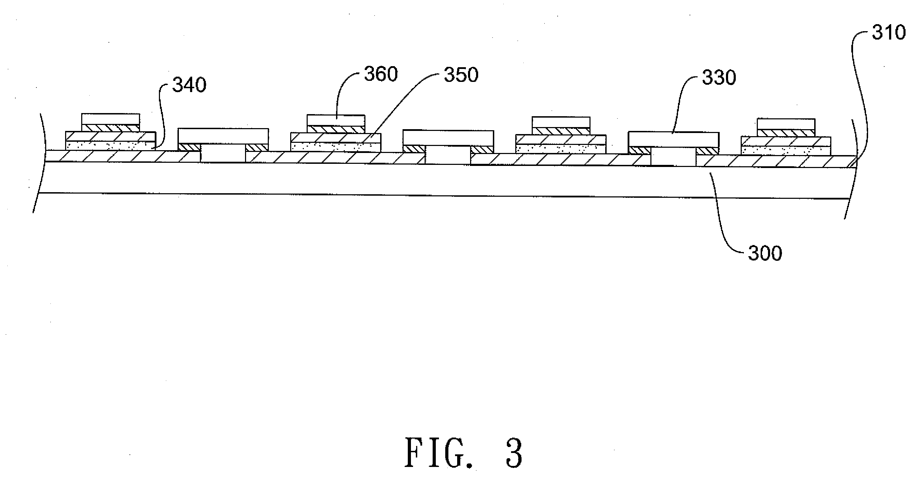

FIG. 3 is a cross-sectional diagram of the plane structure of the light-emitting diode lighting apparatus in accordance with a third example.

A first transparent pattern is positioned on a transparent flexible tape 300, wherein the first transparent pattern is a plurality of first transparent conductive lines 310 in this embodiment, but not limited to. For the difference between this example and the aforementioned examples and embodiments, the second transparent pattern further includes a patterned insulation layer 340 disposed on the first transparent conductive lines 310, but two ends of the first transparent conductive lines 310 and the places which are going to place the first light-emitting diodes 330 are exposed out of the patterned insulation layer 340. The exposed ends of the first transparent conductive lines 310 are connected to a plurality of first light-emitting diodes 330. Next, in addition to the first transparent conductive lines 310, the first transparent pattern further includes a plurality of second transparent conductive lines 350 on the patterned insulation layer 340. The layout of the second transparent conductive lines 350 may be overlapped across the first transparent conductive lines 310. A plurality of second light-emitting diodes 360 is attached and electrically connected to the second transparent conductive lines 350. In the example, the first transparent pattern is the first transparent conductive line 310 or the combination of the first transparent conductive line 310 and the second transparent conductive line 350 thereof, but not limited to, and the first transparent pattern can also be a transparent conductive film, which is aforementioned on the first embodiment. It is understood that another plane structure of the light-emitting diodes lighting apparatus form, which is the same as the previous example, may also be formed on the other surface of the transparent flexible tape 300 to establish a double-side, multi-storey light-emitting diodes lighting apparatus. And the only criterion to establish such a double-side, multi-storey light-emitting diodes lighting apparatus is that all light-emitting diodes of the lighting apparatus have to overlapped across positioned, as this result, the light-emitting diodes lighting apparatus can display the visual arts.

Accordingly, one or more layers of light-emitting diodes may be stacked on one or both sides of a flexible plane structure with light-emitting diodes to enhance various applications.

Accordingly, the plane structure of LED lighting apparatus may have the light-emitting diodes in various amounts, sizes or kinds, such as monochromatic or polychromatic light-emitting diodes, in order to provide flexibility on designs. Next, the carrier of the light-emitting diodes made of flexible tape may be cut in various sizes and shapes, and, even more, the done plane structure of light-emitting diodes lighting apparatus may be positioned on a given shape or size carrier, such as a curve carrier, to meet with different designs. Thus, the plane structure of light-emitting diodes lighting apparatus in accordance with the present invention may be applied to indoor/outdoor partition, furniture, table, ceiling, shower partition, glass wall, display window, specific light stand, table decoration, advertisement or display panel, but not limited to.

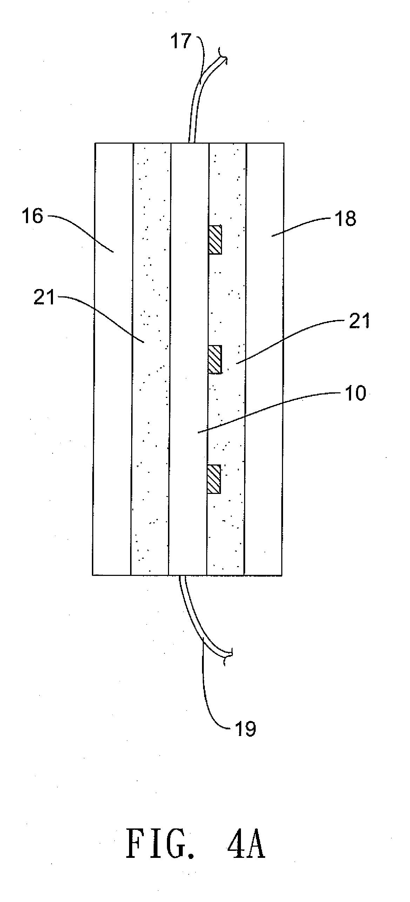

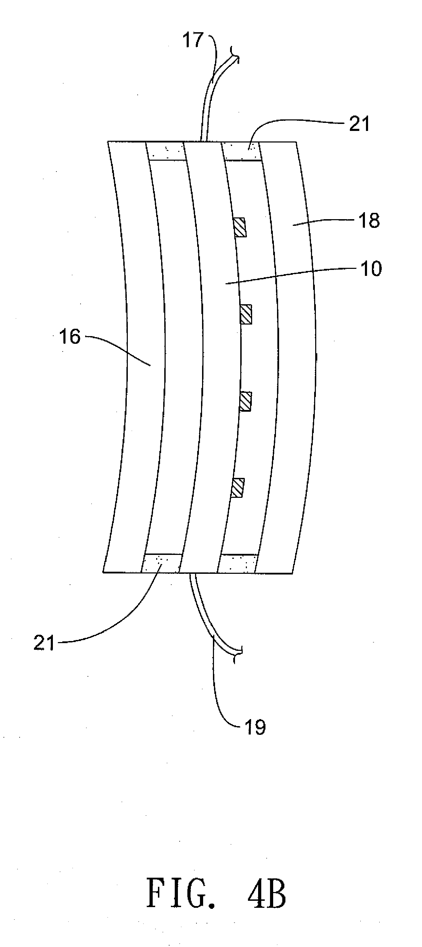

Please refer to FIG. 4A and FIG. 4B, are the side elevation view of a lighting apparatus in accordance with an embodiment of the present invention. The lighting apparatus 10 is inserted between two transparent rigid substrates 16 and 18 to form a light-emitting diodes peripheral product. The lighting apparatus 10 includes a power line 17 and a ground line 19, which are exposed out of the lighting apparatus 10, and an interlayer film 21, which is filled into the space between the lighting apparatus and two transparent rigid substrates 16 or 18 to protect light-emitting diodes. In the embodiment, the interlayer film 21 is made of poly vinyl butyral (PVB), EN, polyethylenenapthalate (PEN), ethyl vinyl acetate (EVA), or gel, but not limited to. And the material of the transparent rigid substrate 16 and 18 can be glass, polycarbonate, plastic, laminated glass or laminated plastic, but not limited to. In addition, the interlayer film 21 may be distributed over the plane structure of light-emitting diodes lighting apparatus (as shown in FIG. 4A) or the periphery of the lighting apparatus 10 (as shown in FIG. 4B).

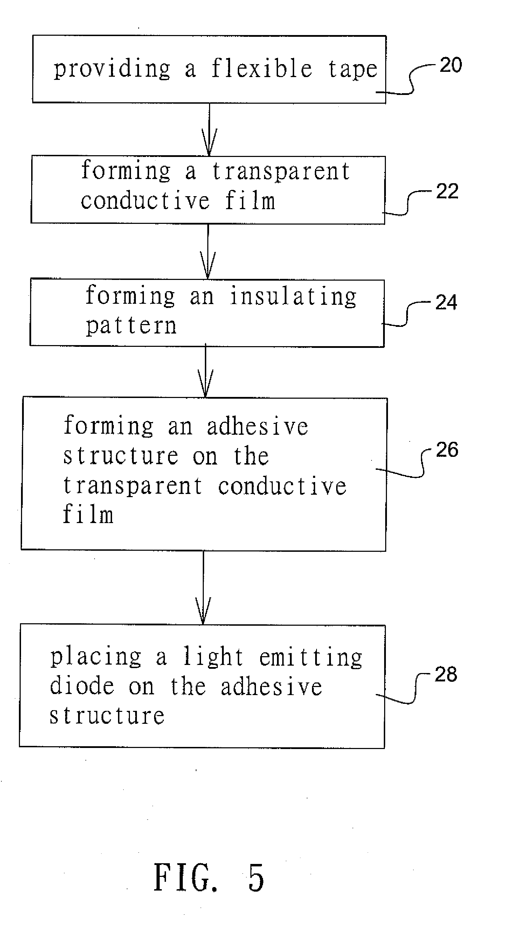

FIG. 5 is a flowchart illustrating the formation of the plane structure of the light-emitting diodes lighting apparatus in accordance with an embodiment of the present invention. A flexible tape is provided (step 20), and a transparent conductive film is formed on one or two sides of the flexible tape by any suitable method (step 22), such as sputtering, evaporate plating, printing, coating or film attaching. Next, an insulating pattern is done on the transparent conductive film in laser cutting, chemical etching or cutting (step 24). In one embodiment, the insulating pattern may include some lines to divide the transparent conductive film into some blocks, but not limited to the lines in the present invention. Some adhesive structures are formed on the pre-determined positions of the transparent conductive film (step 26), such as some conductive adhesive pads, which are formed by dipping method. Next, light-emitting diodes are attached on the adhesive structures (step 28). Alternatively, the dipping method is also employed to form conductive adhesive points directly on the pins of every light-emitting diodes, such as silver gel or solder on the pins, and then light-emitting diodes can be attached on the transparent conductive film.

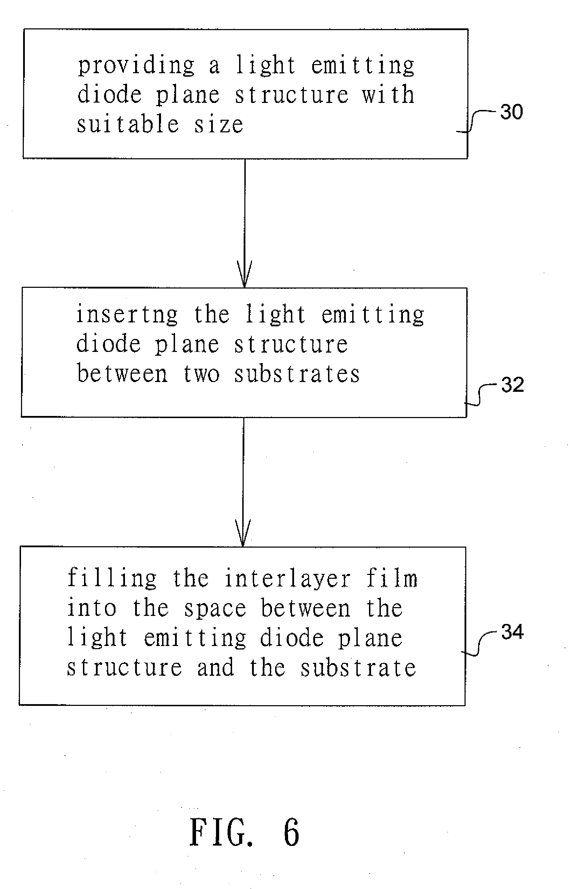

FIG. 6 is a flowchart illustrating the formation of the plane structure of the light-emitting diodes lighting apparatus in accordance with another embodiment of the present invention. The plane structure of the present invention may be fixed on any suitable substrate. In another example, the plane structure of light-emitting diodes lighting apparatus according to the process shown in FIG. 1A may be cut into various sizes for different designs to provide coming assembly (step 30). It is understood that a flexible tape in any shape may be provided before the manufacture of the plane structure of light-emitting diodes lighting apparatus. Next, the plane structure of light-emitting diodes lighting apparatus may be inserted between two substrates (step 32), such as two transparent rigid glass substrates. Interlayer film is filled into the space between the plane structure of light-emitting diodes lighting apparatus and each substrate to protect light-emitting diodes (step 34). The interlayer film may be distributed on the periphery of the plane structure of light-emitting diodes lighting apparatus or over the plane structure of light-emitting diodes lighting apparatus. Alternatively, the interlayer film may be coated on a first substrate before the plane structure of light-emitting diodes lighting apparatus is positioned. Then the interlayer film (or the other) is coated on the plane structure on light-emitting diodes lighting apparatus and then covered with a second substrate.

Although the present invention has been explained in relation to its preferred embodiment, it is to be understood that other modifications and variation can be made without departing the scope of the invention as hereafter claimed.

## Claims

1. A plane structure of a light-emitting diode lighting apparatus, comprising:
a transparent flexible tape (400);
an electrically conductive transparent pattern (420) and an electrically insulating transparent pattern (410) disposed on said transparent flexible tape (400), wherein said conductive transparent pattern (420) is divided into a first zone (460) and a second zone (470) in the same plane by said insulating transparent pattern (410), and said first zone (460) comprises a plurality of first discontinuous blocks electrically connected to an exterior first electrode and said second zone (470) comprises a plurality of second discontinuous blocks electrically connected to an exterior second electrode; the first and second discontinuous blocks being divided by the electrically insulating transparent pattern; and
a plurality of light-emitting diodes (430) on said transparent flexible tape (400), wherein each of said light-emitting diodes (430) has a positive electrode fixed on one of said first blocks (460) and a negative electrode fixed on one of said second blocks (470).

2. A plane structure of a light-emitting diode lighting apparatus according to claim 1, wherein said conductive transparent pattern (420) is made of material selected from the groups consisting of transparent acrylic conductive gel, indium tin oxide, and indium zinc oxide.

3. A plane structure of a light-emitting diode lighting apparatus according to claim 1, wherein said insulating transparent pattern (410) comprises at least one of a surface of said transparent flexible tape (400) or an insulating layer on said transparent flexible tape (400).

4. A plane structure of a light-emitting diode lighting apparatus according to claim 1, further comprising:
two transparent rigid substrates (16, 18), wherein said transparent flexible tape (400), said conductive transparent pattern (420), said insulating transparent pattern (410) and said light-emitting diodes (430) are positioned between said two transparent rigid substrates (16, 18); and an interlayer film (21) positioned between said transparent flexible tape (400) and
one of said transparent rigid substrates (16, 18).

## Patentansprüche

1. Flächenstruktur einer Leuchtdioden-Beleuchtungsvorrichtung, umfassend:
ein transparentes flexibles Band (400);
ein elektrisch leitfähiges, transparentes Muster (420) und
ein auf dem transparenten flexiblen Band (400) angeordnetes, elektrisch isolierendes, transparentes Muster (410), wobei das leitfähige transparente Muster (420) durch das isolierende transparente Muster (410) auf der gleichen Fläche in eine erste Zone (460) und eine zweite Zone (470) unterteilt ist und die erste Zone (460) eine Vielzahl von ersten unterbrochenen Blöcken umfasst, die elektrisch mit einer externen ersten Elektrode verbunden sind, und die zweite Zone (470) eine Vielzahl von zweiten unterbrochenen Blöcken umfasst, die elektrisch mit einer zweiten externen Elektrode verbunden sind; wobei die ersten und die zweiten unterbrochenen Blöcke durch das elektrisch isolierende Muster getrennt sind; und
eine Vielzahl von Leuchtdioden (430) auf dem transparenten flexiblen Band (400), wobei jede der Leuchtdioden (430) eine positive, auf einem der ersten Blöcke (460) befestigte Elektrode und eine negative, auf einem der zweiten Blöcke (470) befestigte Elektrode umfasst.

2. Flächenstruktur einer Leuchtdioden-Beleuchtungsvorrichtung gemäß Anspruch 1, wobei das leitfähige, transparente Muster (420) aus einem Material hergestellt ist, welches aus den Gruppen bestehend aus transparentem, leitfähigem Acryl-Gel, Indium-Zinnoxid, und Indium-Zinkoxid gewählt ist.

3. Flächenstruktur einer Leuchtdioden-Beleuchtungsvorrichtung gemäß Anspruch 1, wobei das isolierende, transparente Muster (410) mindestens eine der Oberflächen des transparenten flexiblen Bandes (400) oder eine isolierende Schicht auf dem transparenten flexiblen Band (400) umfasst.

4. Flächenstruktur einer Leuchtdioden-Beleuchtungsvorrichtung gemäß Anspruch 1, weiterhin umfassend:
zwei transparente starre Substrate (16, 18), wobei das transparente flexible Band (400), das leitfähige transparente Muster (420), das isolierende transparente Muster (410) und die Leuchtdioden (430) zwischen den zwei transparenten starren Substraten (16, 18) angeordnet sind; und
ein Zwischenschichtfilm (21) ist zwischen dem transparenten flexiblen Band (400) und einer der transparenten starren Substrate (16, 18) angeordnet.

## Revendications

1. Structure plane d'appareil d'éclairage à diodes électroluminescentes comprenant:
un ruban flexible transparent (400);
une configuration transparente conductrice électriquement (420) et
une configuration transparente isolée électriquement (410) disposées sur le ruban flexible transparent (400), la configuration transparente conductrice (420) étant divisée en une première zone (460) et en une seconde zone (470) sur la même plane par la configuration transparente isolante (410) et la première zone (460) comprenant plusieurs premiers blocs discontinus connectés électriquement à une première électrode extérieure et la seconde zone (470) comprenant plusieurs seconds blocs discontinus connectés électriquement à une seconde électrode extérieure ; les premiers et seconds blocs discontinus étant divisés par la configuration transparente isolée électriquement;
et plusieurs diodes électroluminescentes (430) sur le ruban flexible transparent (400), chacune des diodes électroluminescentes (430) ayant une électrode positive fixée sur un des premiers blocs (460) et une électrode négative fixée sur un des seconds blocs (470).

2. Structure plane d'appareil d'éclairage à diodes électroluminescentes selon la revendication 1, la configuration transparente conductrice (420) étant faite de matériaux sélectionnés à partir de groupes composés d'un gel conducteur en acrylique transparent, d'oxyde étain-indium et d'oxyde de zinc-indium.

3. Structure plane d'appareil d'éclairage à diodes électroluminescentes selon la revendication 1, la configuration transparente isolante (410) comprenant au moins une surface de ruban flexible transparent (400) ou une couche isolante sur le ruban flexible transparent (400).

4. Structure plane d'appareil d'éclairage à diodes électroluminescentes selon la revendication 1 comprenant également:
deux substrats rigides transparents (16,18), le ruban flexible transparent (400), la configuration transparente conductrice (420), la configuration transparente isolante (410) et les diodes électroluminescentes (430) étant positionnés entre les deux substrats rigides transparents (16, 18) ; et un film intermédiaire (21) étant positionné entre le ruban flexible transparent (400) et l'un des substrats rigides transparents (16,18).
